(19) Europäisches Patentamt
European Patent Office
Office européen des brevets

(11) Publication number: **0 278 147 A1**

# (12) EUROPEAN PATENT APPLICATION

(21) Application number: **87305153.6**

(22) Date of filing: **10.06.87**

(51) Int. Cl.⁴: **H 02 H 11/00**, G 01 R 31/02

(30) Priority: **10.06.86 GB 8614128**

(43) Date of publication of application: **17.08.88 Bulletin 88/33**

(84) Designated Contracting States: **DE FR GB IT NL SE**

(71) Applicant: **Kenure Developments Limited, Blackwater Station Estate, Camberley Surrey GU17 9AQ (GB)**

(72) Inventor: **Andrews, Clive William Dempster, 165 Keith Lucas Road, Farnborough Hampshire (GB)**
Inventor: **Hutchinson, Malcolm, 53 Bearwood Road, Barkham Wokingham Berkshire (GB)**

(74) Representative: **Robinson, John Stuart et al, MARKS & CLERK 57/60 Lincoln's Inn Fields, London WC2A 3LS (GB)**

## (54) Earth monitoring apparatus.

(57) An apparatus is provided for monitoring the earthing of an installation which receives alternating supply current of a first frequency and which is provided with earth leakage protection. Injecting means (12, 28, 29, 30) injects alternating current of a second frequency into an earthing conductor and measuring means (13, 31, 32, 33) measures the resulting current flowing through the conductor so as to provide a measure of earth impedance. The earth leakage protection is insensitive to current of the second frequency. When the earth impedance is too high for proper operation of the earth leakage protection, a warning indication is given.

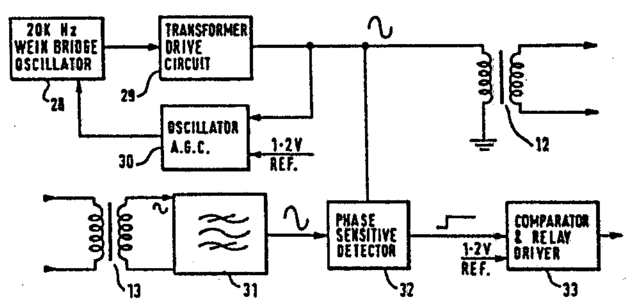


EP 0 278 147 A1

M&C FOLIO : 799P51508 WANG DOC : 0244K

# IMPROVEMENTS IN OR RELATING TO EARTH MONITORING

The present invention relates to an apparatus for earth monitoring.

Electrical and Electronic equipment is generally provided with an earth connection for safety reasons. For instance, when such equipment is provided with a metal case or chassis, the case or chassis is connected to earth so that no harmful or dangerous voltage can appear on it if a fault develops in the equipment. For fixed equipment supplied with mains power, the earth connection may be provided by the mains earth connection. For mobile equipment mounted in a vehicle, a local earth connection is frequently provided by driving a metal spike into the ground.

In recent years, it has become more common to provide earth leakage protection. A common technique for providing earth leakage protection involves monitoring the voltage or the current flowing between an earthing point and an equipment earth terminal. If the level of this voltage or current exceeds a predetermined value, the power supply to the equipment is disconnected so as to avoid injury or damage. However, such protection is only effective if the earth connection presents a sufficiently low impedance to current resulting from an undesirable voltage appearing at the equipment earth terminal. If the earth connection has too high an impedance, the earth leakage protection can become ineffective and dangerous voltages may appear on the equipment chassis or case.

GB 532 476 discloses an arrangement for measuring the earth impedance of a main earth. An alternating current is caused to flow between the main earth and an auxiliary earth. The potential difference between the main earth and an earthed test conductor is measured and the quotient of the rectified potential difference and the rectified alternating current gives the main earth impedance.

GB 543 660, GB 798 557, GB 1 326 948, US 723 863, and US 4 394 615 disclose arrangements for detecting faults in the leads and contacts of equipment, which leads and contacts are used to connect the equipment to an earth.

EPO 054 940 discloses an arrangement for checking whether electrical equipment has been properly earthed so as to avoid accidents or injury. The continuity for alternating current between a power supply earth line, to which the equipment is connected, and a separate earth connection to the equipment housing is monitored in case the earth connection is broken or faulty.

EPO 112 200 discloses an adaptor for adapting a conventional multimeter to perform a "three electrode" earth impedance measurement of the type illustrated in GB 532 476.

According to the invention, there is provided a protection apparatus for monitoring earthing of an installation which is connected to earth by a conductor and which is arranged to receive alternating supply current of a first frequency, comprising earth leakage detection means for detecting earth leakage current of the first frequency through the conductor, characterised by further comprising means for injecting into the conductor alternating current of a second frequency different from the first frequency, measuring means for measuring the resulting current of the second frequency flowing through the conductor to earth, and means for indicating when the level of the resulting current is less than a predetermined level, the earth leakage detection means being substantially insensitive to alternating current of the second frequency.

It is thus possible to provide an apparatus which monitors the condition of an earth connection for equipment whose chassis or case is to be earthed for safety reasons. Even where such equipment is provided with earth leakage protection of the type which monitors current or voltage in the earth connection, it is necessary to monitor the earth connection to ensure that the earth leakage protection is effective.

In mobile equipment, one end of the conductor may be connected to a main earth and the other end may be connected to a safety monitor earth, the apparatus effectively monitoring the impedance between the two earths.

Preferably the injecting means is arranged to inject an alternating current whose frequency lies in a range whose lower limit is 2 kHz, more preferably 5 kHz, and whose upper limit is 100 kHz, more preferably 50 kHz. A frequency substantially equal to 20 kHz has been found advantageous as this is generally too high to cause audible interference and low enough not to produce noise or radio frequency interference. This also allows the earth impedance to be monitored at a frequency which is sufficiently removed from normal mains frequencies and power supply frequencies so that the injected alternating current does not interfer with the operation of earth leakage protection and monitoring is substantially unaffected by mains noise or breakthrough.

Preferably the injecting means includes a transformer whose secondary winding is connected in series with the conductor. This provides a convenient means for injecting alternating current into the conductor.

Preferably the measuring means includes a phase sensitive detector arranged to perform phase detection between the alternating current from the injecting means and the resulting current. This ensures that the detecting means is sensitive only to the injected current and allows the apparatus to be used in noisy environments. The apparatus is thus made substantially insensitive to signals which are of a different frequency from the injected current, and provides additional security in that only signals with a fixed phase relationship to the injected current are measured. Preferably the measuring means includes a bandpass filter connected between the conductor and the phase sensitive detector and tuned to the second frequency. This provides additional security against incorrect measurements in a noisy environment.

Preferably the measuring means includes a current transformer whose primary winding is connected in series with the conductor. This provides a convenient way of connecting the measuring means to the conductor without substantially affecting the impedance.

Preferably the measuring means includes a comparator for producing an output signal when the resulting current is less than a predetermined value. Thus, an output signal is produced when the earth impedance is higher than a predetermined value, for instance such that earth leakage protection ceases to be properly effective.

The indicating means may provide visual or audible warning when the earth impedance is too high for correct functioning of earth leakage protection.

Preferably the earth leakage detection means includes a filter for attenuating signals whose frequency is outside a frequency band including the first frequency. Such filtering improves the reliability of the earth leakage protection by attenuating or rejecting signals which are unrelated to earth leakage caused by fault conditions within equipment being monitored. The filtering also allows the injected current to be ignored by the earth leakage protection.

Preferably the earth leakage detection means includes comparator means for producing a fault signal when the amplitude of the positive or negative peaks of the alternating earth leakage current exceeds a predetermined amplitude. The use of an AC-coupled comparator avoids the delays associated with conventional DC comparators which employ rectification and smoothing.

Thus, the response of the earth leakage protection is not impaired and a fault condition can be detected within half a cycle of an alternating current mains supply.

It is thus possible to monitor the effectiveness of earth leakage protection in an installation, such as mobile electronic equipment, so as to detect potentially dangerous situations. In known arrangements of the type described hereinbefore where earth leakage protection was provided, it was assumed that this protection was adequate to prevent the occurrence of potentially dangerous situations. No attempt was made to monitor the effectiveness of the "current leakage" earth.

Conversely, in arrangements of the type described hereinbefore where the earthing connection was monitored, the possibility of the occurrence of a dangerous situation was indicated even though the equipment itself might well have been capable of operating without risk.

The present invention maximises the utility of equipment by providing a warning only when earthing is insufficient to ensure correct operation of the earth leakage protection. Thus, in the absence of any warning indication, the installation is fully protected against undesirable voltage levels appearing on casing or other exposed parts. The earth leakage protection can operate with an earth impedance which is much greater than that required for "safe" earthing of the installation so that the installation can be safely used in circumstances where known arrangements would dictate that the installation were unsafe for use. This is especially advantageous for mobile installations for use in the field, where reliance has to be placed on a temporary earth which might well not be considered adequate by conventional criteria.

Even if a warning is given that the earth leakage protection is doubtful, an operator can assess whether it is necessary to switch off the equipment or whether operation may continue, perhaps with some precautions being taken. Thus, although the earth leakage protection may not be completely effective, an operator is warned of this condition and can still be safeguarded against possible injury if it is essential to continue to operate the installation.

Not only is safety improved, but the installation may continue to operate safely in circumstances where it would have been unsafe if only previously known safety measures had been available.

The invention will be further described, by way of example, with reference to the accompanying drawings, in which:

Figure 1 illustrates connections to an earth leakage trip and monitoring apparatus constituting a preferred embodiment of the present invention;

Figure 2 is a block diagram of the apparatus of Figure 1;

Figure 3 is a more detailed block diagram of part of the apparatus of Figure 1;

Figure 4 is a more detailed block diagram of another part of the apparatus of Figure 1; and

Figure 5 is a detailed circuit diagram of the apparatus of Figure 1.

The apparatus of Figure 1 is intended for installation in a vehicle for providing protection against earth faults in equipment installed in the vehicle. The apparatus 1 receives a 32 volt direct current supply which is derived from 250 volt 50 Hz mains supply. A single phase mains supply is shown, but the apparatus works equally well with three phase supplies. The negative line of the 32 volt supply is connected to a chassis earth stud 2 of the vehicle or the equipment mounted therein, which stud is also separately connected to the apparatus 1. The apparatus is further connected to a safety monitor earth stud 3 which is connected to an earth spike driven into the ground.

Red and green lamps 4 and 5, respectively, are provided for indicating the condition of the earth connection. If the earth impedance is too high for safe or correct operation of the earth leakage protection, the red lamp 4 is illuminated. If the earth impedance is sufficiently low for correct operation, the green lamp 5 is illuminated. When the red lamp 4 is illuminated to indicate a potentially unsafe situation, an operator can judge whether to continue using apparatus connected to the supply or to disconnect or switch off the supply. Alternatively, a trip arrangement (not shown) may be provided to cut off the supply when a potentially unsafe condition is detected.

The apparatus 1 has inputs for receiving a test voltage supply, for testing correct operation of the earth leakage protection, via a dual pole EL test switch 6 biased to its off position. One of the poles is connected to the neutral line of a mains supply input whereas the other pole is connected via an earth leakage reset switch 7 and a contactor 8 to the live line. The apparatus 1 also includes a relay which is operated in the presence of an earth leakage current exceeding a predetermined value having a contact connected between the switch 7 and the contactor 8. In many applications, the contactor 8 and its connections can be ommitted without otherwise affecting operation of the apparatus.

As shown in Figure 2, the apparatus comprises a conductor connected between the chassis earth stud 2 and the safety monitor earth stud 3. Connected in series with this conductor are: the secondary of an injection test voltage transformer 9 which has a mains primary winding; a current limiting series resistor 10; the primary of a 50 Hz current transformer 11; the secondary of a 20 kHz injection transformer 12; and the primary of a 20 kHz current transformer 13.

The apparatus includes an input power supply regulator 14 which receives the unsmoothed direct current supply whose voltage is nominally 32 volts but which may vary between 28 and 36 volts. The regulator 14 provides a regulated + and - 12 volt direct current supply for the electronics of the apparatus as indicated at 15.

The secondary winding of the transformer 11 is connected to the input of an earth leakage monitor circuit 16 which provides an output for actuating a trip relay 17 when an earth leakage current or voltage is detected having a value greater than a predetermined value. The relay 17 has a pair of normally closed contacts 18 which are connected to the contact breaker coil and reset switch within the earth leakage reset switch 7.

The primary winding of the transformer 12 and the secondary winding of the transformer 13 are connected to a 20 kHz injection and monitor circuit 19 whose output controls a relay 20. The relay 20 has a pair of normally closed contacts 21 for the red light 4 and a pair of normally open contacts 22 for the green light 5. The injection and monitor circuit 19 is therefore fail safe in that, in the event of power failure or a power supply fault, the red light 4 is illuminated to indicate an unsafe condition.

The earth leakage monitor circuit 16 is shown in more detail in Figure 3. The secondary winding of the 50 Hz current transformer 11 is connected to the input of an amplifier and lowpass filter 23. The filter comprises a three pole butterworth lowpass filter with a turnover frequency of 200 Hz. This allows earth leakage fault signals, which have a frequency of 50 Hz, to pass without substantial time delay but attenuates or removes higher frequency signals.

The output of the filter and amplifier 23 is connected to a circuit 24 which includes a pair of AC-coupled comparators for comparing the positive and negative half-cycles of the signal with a reference voltage V ref of 1.2 volts. The outputs of the comparators are connected together and form the output of the circuit 24 which is connected to the trigger input of a monostable multivibrator 25. The monostable multivibrator has a time constant of 100 milliseconds and supplies its output signal to a relay driver circuit 26 whose output 27 controls the trip relay 17. This time constant is sufficiently long to allow the main contactor 8 to open and clear the fault before reset occurs.

The injection and monitor circuit 19 is shown in more detail in Figure 4 and comprises a 20 kHz Wein bridge oscillator 28 connected to a transformer driver circuit 29. The output of the driver circuit 29 is connected to the input of an oscillator automatic gain control circuit 30 which also receives a 1.2 volt reference voltage and controls the amplitude of the output signals from the oscillator 28 so that this amplitude is maintained constant. The output of the drive circuit 29 is connected to the primary winding of the transformer 12 which has a primary-to-secondary winding ratio of 1:1.

The secondary winding of the current transformer 13 is connected to the input of an amplifier and bandpass filter circuit 31. The filter comprises a first-order bandpass filter tuned to 20 kHz and having a Q factor of 5 so as to improve the noise and interference rejection performance of the monitor circuit. The output of the circuit 31 is connected to the first input of a phase sensitive detector 32 whose second input is connected to the output of the driver circuit 29 so as to receive the signal therefrom as reference signal. The output of the phase sensitive detector 32 is proportional to the amplitude of any current passing between the chassis earth stud 2 and the safety monitor earth stud 3 and having a frequency of 20 kHz and a phase which is in phase or in anti-phase with the output signal of the driver circuit 29. The phase sensitive detector 32 is arranged to have a base-band width of 3 Hz. Thus, the filter in the circuit 31 and the phase sensitive detector 32 provide a very high degree of immunity to signals other than the injected alternating current signal of 20 kHz supplied by the oscillator 28, the driver circuit 29, and the transformer 12 to the conductor between the studs 2 and 3.

The output signal from the phase sensitive detector 32 is supplied to a comparator and relay driver 33 which compares the signal from the phase sensitive detector 32 with a reference signal derived from the 1.2 volt reference. If the current passing through the primary winding of the transformer 13 is such as to indicate an earth impedance greater than a predetermined acceptable value, the driver 33 prevents the relay 20 from operating so that the red light 4 is illuminated to indicate an unsafe condition.. Alternatively, if the alternating current is such as to indicate an earth impedance less than the predetermined acceptable value, the comparator and relay driver 33 actuates the relay 20 so as to extinguish the red light 4 and illuminate the green light 5 to indicate a safe condition for operation of the earth leakage monitor circuit 16.

Figure 5 is a detailed circuit diagram of the apparatus 1. The input regulator 14 includes a voltage dependent resistor or varistor 34 for suppressing voltage spikes and a common mode RF suppression filter comprising chokes 35 and 36 and capacitors 37 to 40. A diode bridge comprising diodes 41 to 44 prevents damage from incorrect power supply polarity connection. A smoothing capacitor 45 is connected across the output of the diode bridge and is connected via a current limiting resistor 46 to a voltage regulation circuit comprising an integrated circuit voltage regulator type LM 117K 47, a transistor 48, a zener diode 49, diodes 50 to 52, resistors 53 to 59, capacitors 60 to 65, and a further zener diode 66. The input regulator 14 is essentially conventional and will not be described further.

Voltage dependent resistors or varistors 67 to 70 are connected to the terminals of the apparatus for suppressing voltage peaks or transients.

The lowpass filter 23 comprises an integrated circuit operational amplifier 71 provided with resistors 72 to 75 and capacitors 76 and 77 to form a three pole butterworth lowpass filter with a turnover frequency of 200 Hz. The input of the filter is protected against excess input voltages by anti-parallel diodes 78 and 79. An input impedance-defining resistor 80 is connected across the secondary winding of the transformer 11.

The output of the amplifier 71 is connected via a capacitor 81 and a resistor 82 to the AC-coupled comparators 24. An operational amplifier 83 provided with resistors 84 and 85 and capacitors 86 to 88 is arranged as a high gain inverting amplifier. The output of the amplifier 83 is coupled via a capacitor 89 to the input of a first comparator 90 comprising a comparator integrated circuit type LM 193 and associated resistors 91 to 94 and capacitors 95 and 96.

The output of the amplifier 83 is also connected to a unity gain inverting stage comprising an operational amplifier 97 and associated resistors 98 to 100 and capacitors 101 and 102. The output of the amplifier 97 is connected via a coupling capacitor 103 to the input of another comparator circuit comprising an integrated circuit comparator 104 (second half of the LM 193) and associated resistors 105 to 107.

The two comparators are connected to receive a reference voltage of 1.2 volts provided by a band gap reference diode 108 (integrated circuit type LM 185). The diode 108 is provided with a dropping resistor 109 and a noise-suppressing capacitor 110.

The outputs of the comparators 90 and 104 are connected together and via a diode 111 to the trigger input of a monostable multivibrator providing a pulse width of 100 milliseconds.. The monostable multivibrator 25 comprises an integrated circuit (type "555") 112 and associated resistors 113 to 115 and capacitors 116 to 119. The output of the monostable multivibrator is connected via a potential divider comprising resistors 120 and 121 to the relay driver 26 comprising a transistor 122 connected as a common-emitter switching transistor and provided with back-EMF suppression by a diode 123 and a zener diode 124.

The 20 kHz Wein bridge oscillator 28 comprises an operational amplifier 125 provided with a Wein network comprising resistors 126 and 127 and capacitors 126 and 127, and capacitors 128 and 129. The operational amplifier is provided with a decoupling capacitor 130. The output of the oscillator is connected to the transformer drive circuit 29 which comprises an operational amplifier driving a push-pull transistor output stage comprising transistors 132 and 133, diodes 134 to 137, resistors 138 to 140, and an output capacitor 141. Negative feedback is provided by resistors 142 and 143 and a capacitor 144.

The output of the drive circuit 29 is also connected to the input of the oscillator AGC circuit 30. The circuit 30 comprises an operational amplifier 145, a potential divider comprising resistors 146 and 147, a 1.2 volt voltage reference comprising a band gap diode 148 together with a dropping resistor 149 and a filter capacitor 150, and an output circuit comprising a resistor 151, a diode 152, resistors 153 to 155 and a smoothing capacitor 156.

The output of the circuit 30 is connected to a gain control circuit of the oscillator 28. The gain control circuit comprises a field effect transistor 157 which, together with resistors 158 and 159, forms the bottom limb of a potential divider including a resistor 160 connected across the output of the amplifier 125. The tapping point of the potential divider is connected to the inverting input of the amplifier 125 so that the amplitude of the output signal from the oscillator 28 is stabilized.

The amplifier and filter 31 is provided with anti-parallel diodes 161 and 162 for input protection and an impedance-setting resistor 163 connected across the secondary winding of the transformer 13. The circuit 31 includes an input amplifier formed by an operational amplifier 164, resistors 165 to 168, and capacitors 169 to 171. The resistor 167 is adjustable so as to allow the gain of the amplifier to be adjusted.

The output of the amplifier is connected to the input of the bandpass filter comprising an operational amplifier 172, resistors 173 to 176, and capacitors 177 and 178. The output of the filter is connected via a capacitor 179 and a resistor 180 to the input of an operational amplifier 181 arranged as a differential high gain amplifier including resistors 182 to 184 and capacitors 185 to 187. The output of the amplifier 181 is connected to one input of the phase sensitive detector 32.

The phase sensitive detector comprises a pulse squaring stage including a comparator 188, anti-parallel diodes 189 and 190, resistors 191 and 192, and capacitors 193 and 194. The pulse squaring stage receives the output of the drive circuit 29. The output of the comparator 188 is connected via a diode 195 to provide a first clock signal φ1, and via a network comprising resistors 196 and 197, a capacitor 198 and a diode 199, to an inverting stage comprising a common-emitter connected transistor 200 with a collector load resistor 201. The inverting stage provides a second clock signal

φ2. The clock signals φ1 and φ2 are supplied to the control inputs of integrated circuit analogue gates 202 and 203 formed by an integrated circuit type DG 200A. The output signal of the operational amplifier 181 is connected via the first gate 202 and a resistor 204 across a capacitor 205. The second gate 203 is connected in series with a resistor 206, and the series connection is connected across the capacitor 205. The input of a comparator circuit, comprising a comparator 207 and resistors 208 to 210, is connected to the capacitor 205. The output of the comparator 207 is connected via a potential divider comprising resistors 211 and 212 to a relay driving stage comprising Darlington-connected transistors 213 and 214, a resistor 215, and back-EMF protection diodes 216 and 217. The non-inverting input of the comparator 207 receives the reference voltage from the band gap diode 148.

The operational amplifier 97 is an integrated circuit operational amplifier type TL 071M whereas the other operational amplifiers are provided by twin operational amplifier integrated circuits type TL 072M.

CLAIMS

1. A protection apparatus for monitoring earthing of an installation which is connected to earth by a conductor and which is arranged to receive alternating supply current of a first frequency, comprising earth leakage detection means for detecting earth leakage current of the first frequency through the conductor, characterised by further comprising means (12, 19) for injecting into the conductor alternating current of a second frequency different from the first frequency, measuring means (13, 19) for measuring the resulting current of the second frequency flowing through the conductor to earth, and means (4) for indicating when the level of the resulting current is less than a predetermined level, the earth leakage detection means (11, 16) being substantially insensitive to alternating current of the second frequency.

2. An apparatus as claimed in Claim 1, characterised in that the second frequency is substantially equal to 20 kHz.

3. An apparatus as claimed in Claim 2 or 3, characterised in that the injecting means (12, 19) includes a transformer (12) whose secondary winding is connected in series with the conductor.

4. An apparatus as claimed in any one of the preceding claims, characterised in that the measuring means (13, 19) includes a phase sensitive detector (32) arranged to perform phase detection between the alternating current from the injecting means and the resulting current.

5. An apparatus as claimed in claim 4, characterised in that the measuring means (13, 19) includes a bandpass filter (31) connected between the conductor and the phase sensitive detector (32) and tuned to the second frequency.

6. An apparatus as claimed in any one of the preceding claims, characterised in that the measuring means (13, 19) includes a current transformer (13) whose primary winding is connected in series with the conductor.

7. An apparatus as claimed in any one of the preceding claims, characterised in that the measuring means (13, 19) includes a comparator (33) for producing an output signal when the resulting current is less than the predetermined value.

8. An apparatus as claimed in any one of the preceding claims, characterised in that the earth leakage detection means (11, 16) includes a filter (23) for attenuating signals whose frequency is outside a frequency band including the first frequency.

9. An apparatus as claimed in any one of the preceding claims, characterised in that the earth leakage detection means (11, 16) includes comparator means (24) for producing a fault signal when the amplitude of the positive or negative peaks of the alternating earth leakage current of the first frequency exceeds a predetermined amplitude.

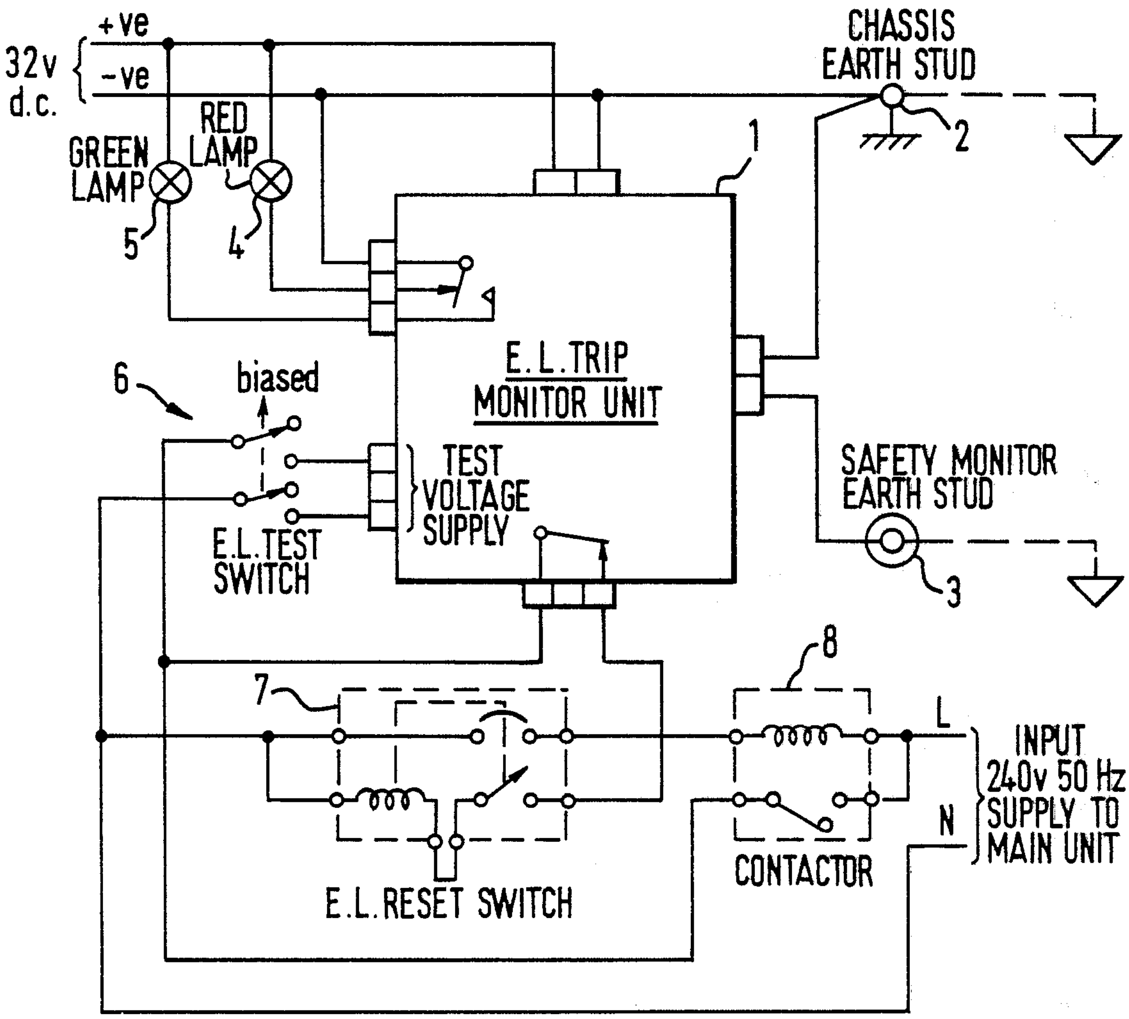

32v d.c.
+ve
-ve
CHASSIS EARTH STUD
GREEN LAMP
RED LAMP
1
2
5
4
E.L.TRIP MONITOR UNIT
6
biased
TEST VOLTAGE SUPPLY
SAFETY MONITOR EARTH STUD
E.L.TEST SWITCH
3
8
7
L
INPUT 240v 50 Hz SUPPLY TO MAIN UNIT
N
CONTACTOR
E.L.RESET SWITCH


FIG.1.

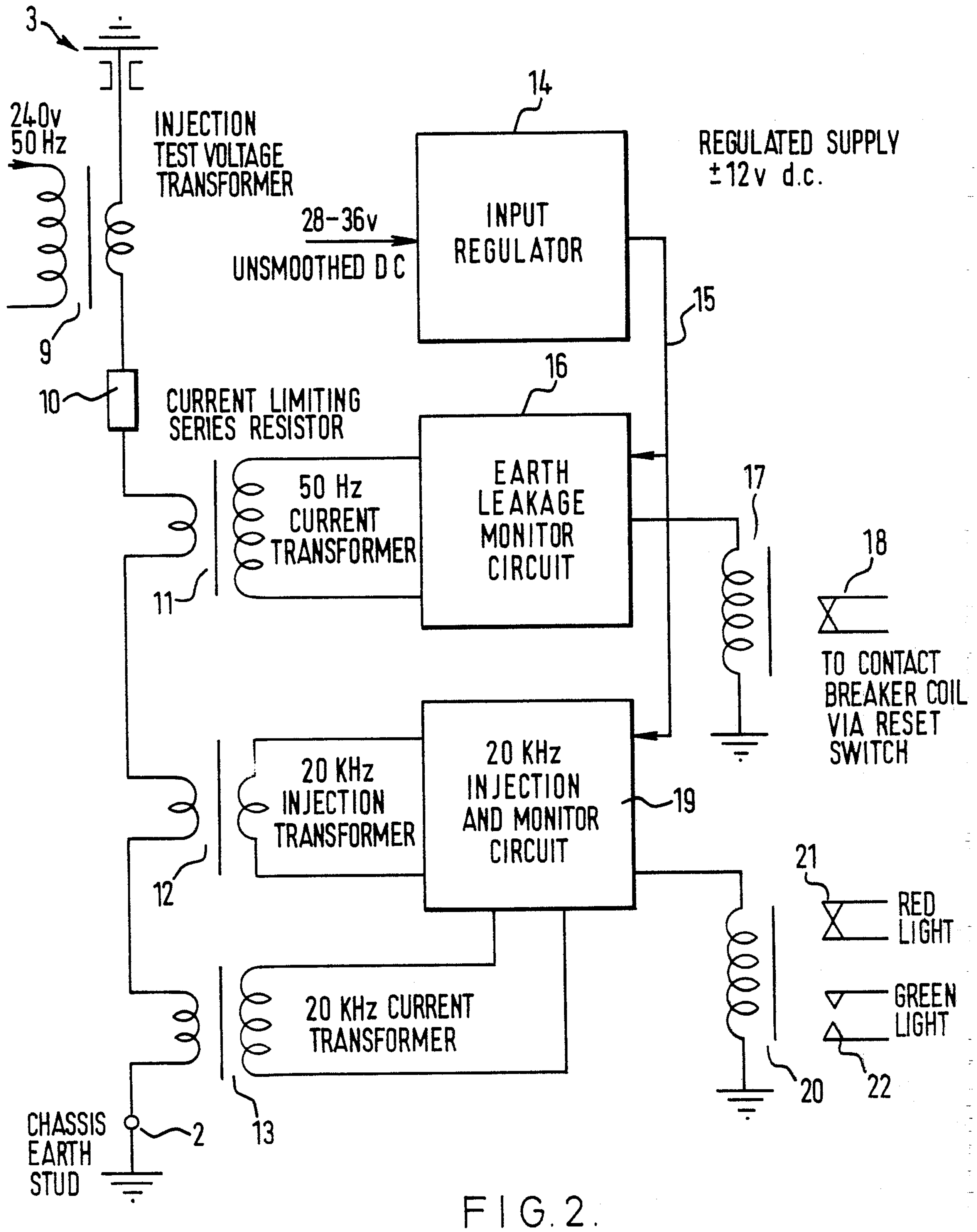
3
240v
50 Hz
INJECTION
TEST VOLTAGE
TRANSFORMER
9
10
CURRENT LIMITING
SERIES RESISTOR
14
INPUT
REGULATOR
28-36v
UNSMOOTHED D C
REGULATED SUPPLY
±12v d.c.
15
16
EARTH
LEAKAGE
MONITOR
CIRCUIT
50 Hz
CURRENT
TRANSFORMER
11
17
18
TO CONTACT
BREAKER COIL
VIA RESET
SWITCH
20 KHz
INJECTION
TRANSFORMER
12
20 KHz
INJECTION
AND MONITOR
CIRCUIT
19
21
RED
LIGHT
GREEN
LIGHT
20 KHz CURRENT
TRANSFORMER
13
20
22
CHASSIS
EARTH
STUD
2

F I G. 2.

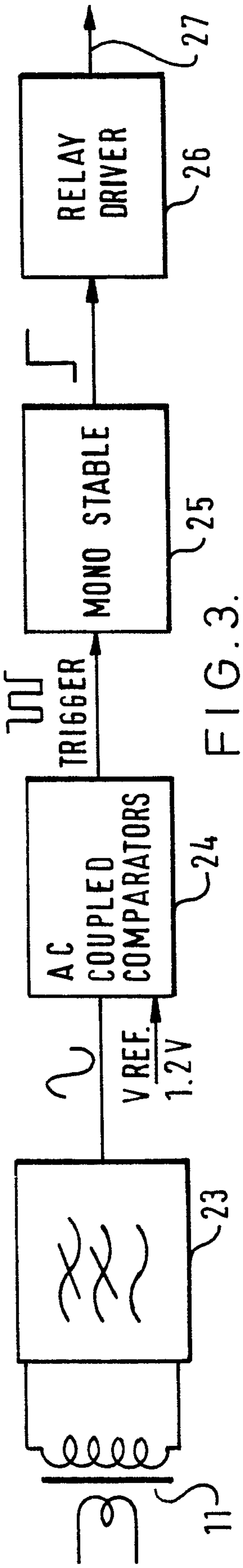
RELAY DRIVER
MONO STABLE
TRIGGER
AC COUPLED COMPARATORS
V REF.
1.2V
11
23
24
25
26
27

FIG.3.

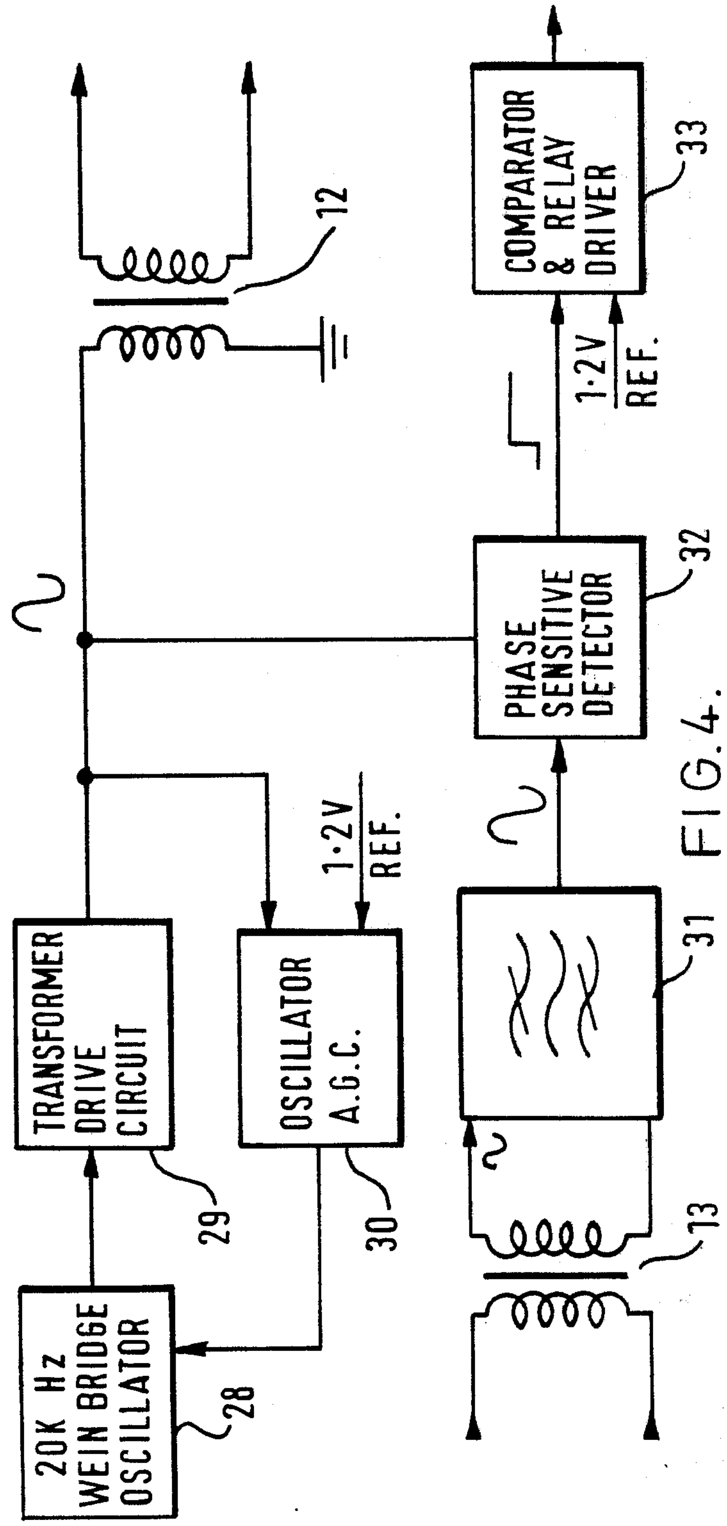
20K Hz WEIN BRIDGE OSCILLATOR
TRANSFORMER DRIVE CIRCUIT
OSCILLATOR A.G.C.
1·2V REF.
PHASE SENSITIVE DETECTOR
COMPARATOR & RELAY DRIVER
1·2V REF.
12
13
28
29
30
31
32
33

FIG.4.

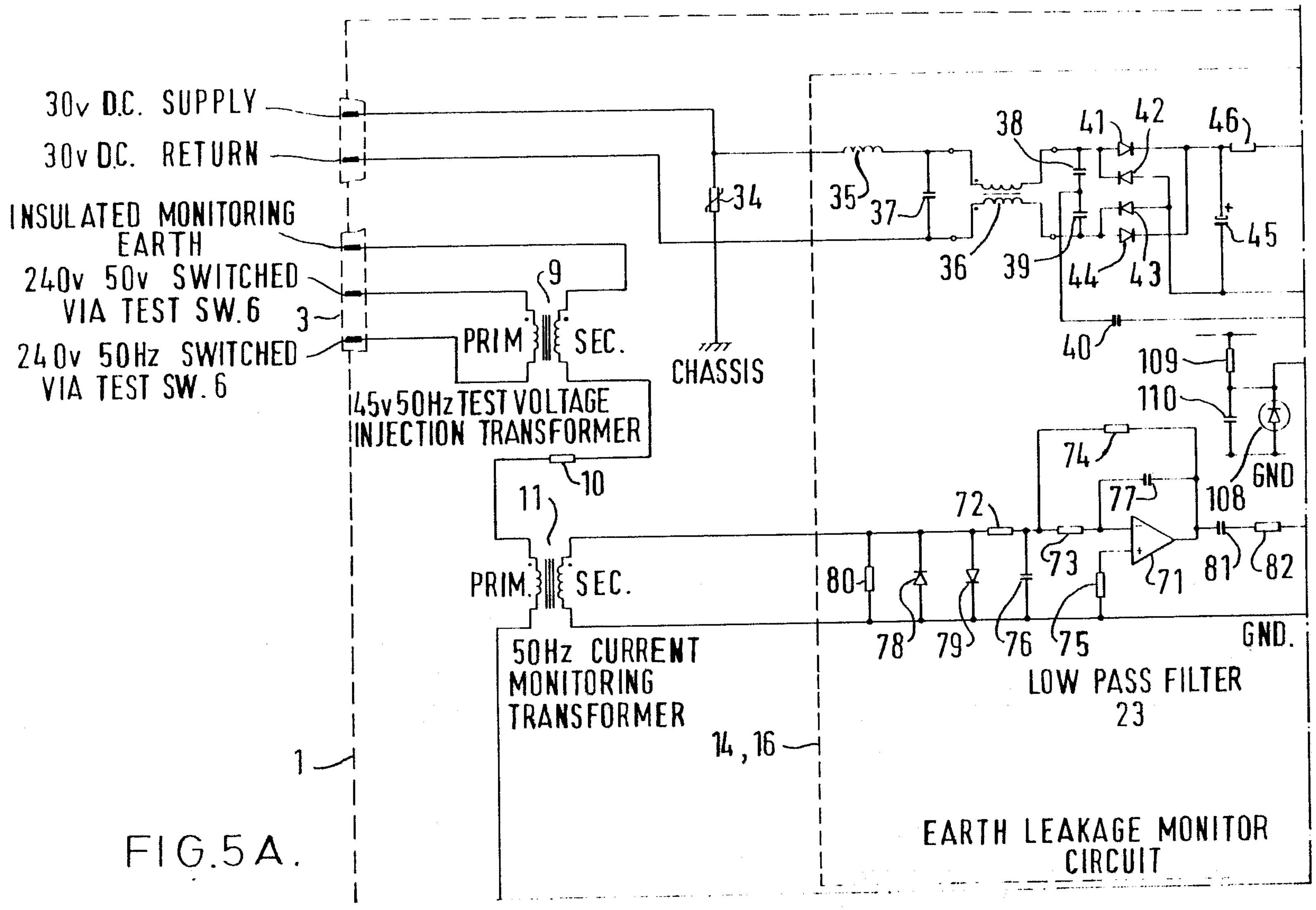
30v D.C. SUPPLY
30v D.C. RETURN
INSULATED MONITORING EARTH
240v 50v SWITCHED VIA TEST SW.6
240v 50Hz SWITCHED VIA TEST SW.6
3
9
PRIM
SEC.
45v 50Hz TEST VOLTAGE INJECTION TRANSFORMER
10
11
PRIM.
SEC.
50Hz CURRENT MONITORING TRANSFORMER
1
34
CHASSIS
14, 16
35
37
36
38
39
41
42
43
44
45
46
40
109
110
108
GND
74
77
71
72
73
75
76
78
79
80
81
82
GND.
LOW PASS FILTER
23
EARTH LEAKAGE MONITOR CIRCUIT

FIG.5A.

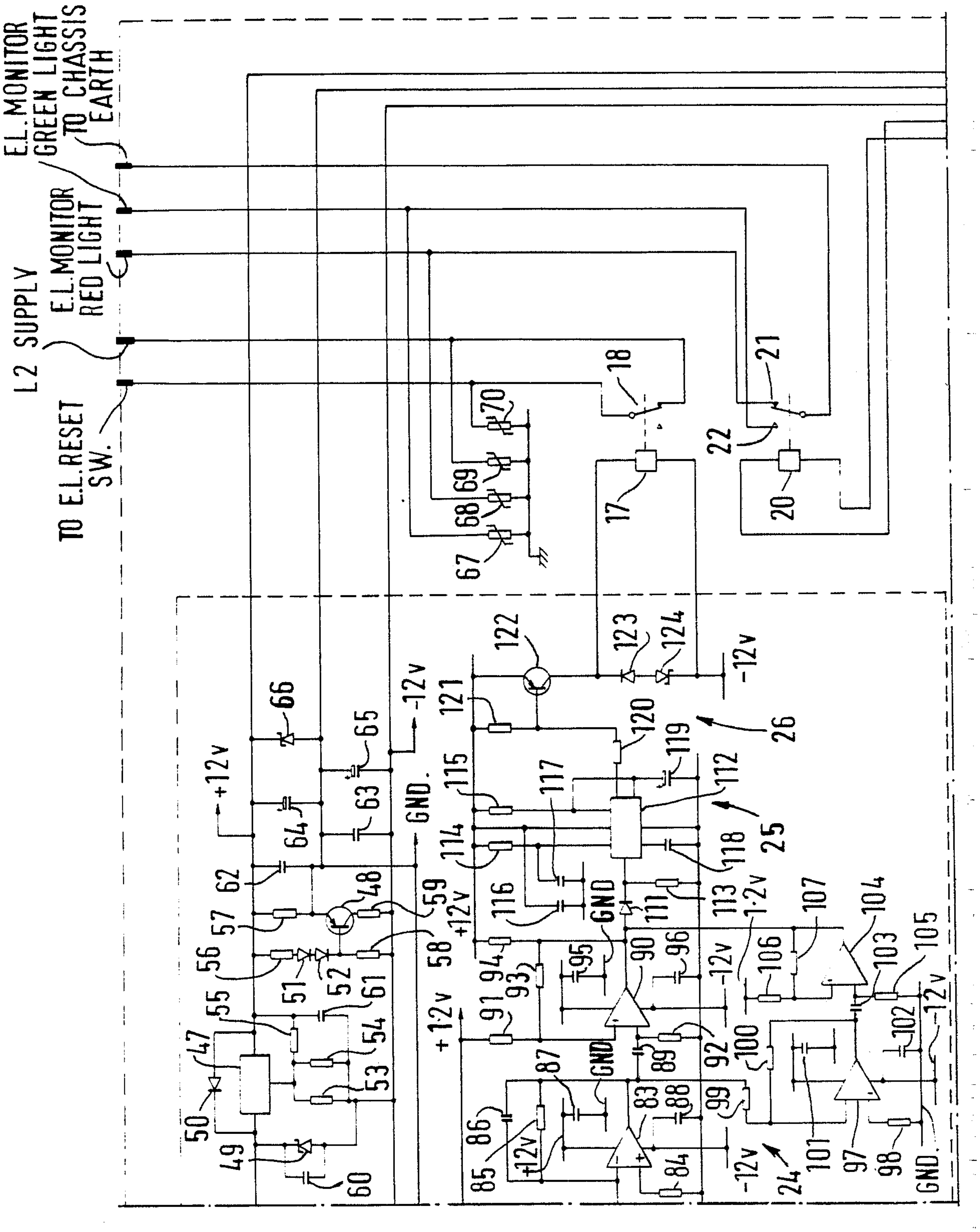
TO E.L.RESET SW.
L2 SUPPLY
E.L.MONITOR RED LIGHT
E.L.MONITOR GREEN LIGHT
TO CHASSIS EARTH
+12v
-12v
GND.
GND
1·2v
+1·2v

FIG.5B.

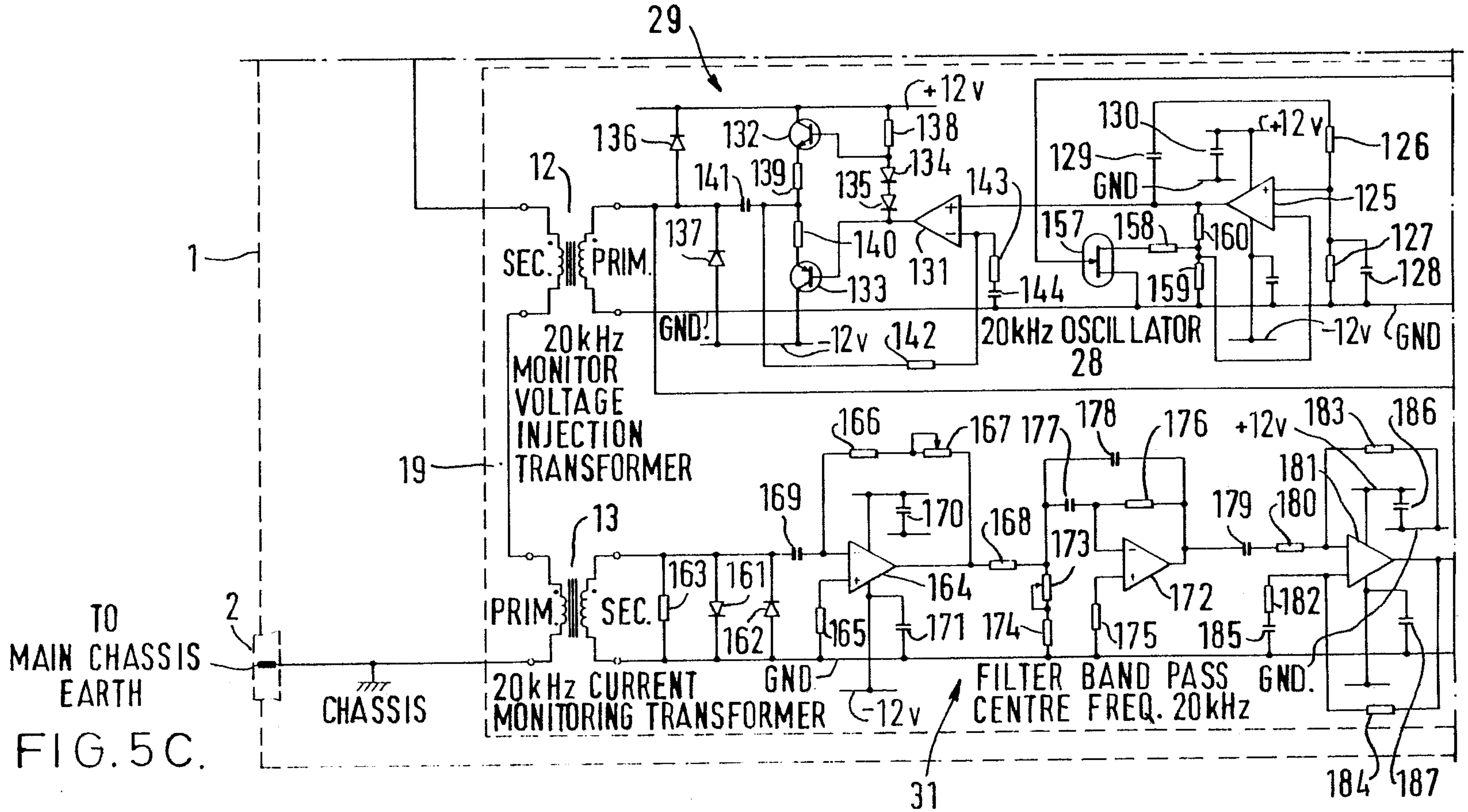
29
+12v
136
132
138
134
135
12
141
139
143
137
140
131
SEC.
PRIM.
133
144
GND.
-12v
142
1
20kHz
MONITOR
VOLTAGE
INJECTION
TRANSFORMER
19
130
+12v
126
129
GND
125
157
158
160
127
128
159
20kHz OSCILLATOR
28
-12v
GND
166
167
177
178
176
+12v
183
186
181
169
170
168
179
180
13
173
163
161
164
172
PRIM.
SEC.
182
165
171
174
175
185
162
GND
-12v
FILTER BAND PASS
CENTRE FREQ. 20kHz
GND.
2
TO
MAIN CHASSIS
EARTH
CHASSIS
20kHz CURRENT
MONITORING TRANSFORMER
31
184
187

FIG.5C.

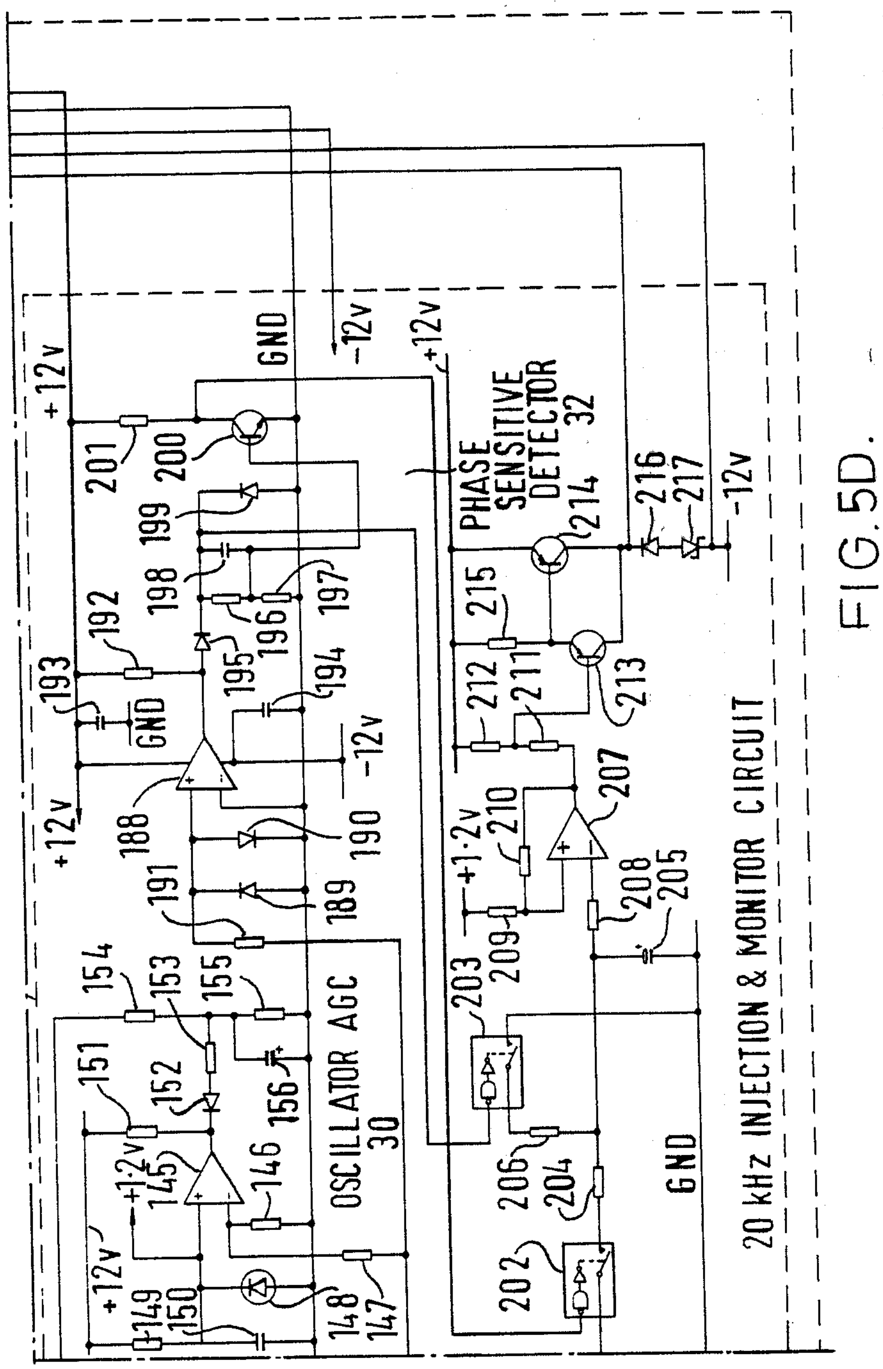
OSCILLATOR AGC
30
PHASE
SENSITIVE
DETECTOR
32
20 kHz INJECTION & MONITOR CIRCUIT
GND
+12v
-12v
+1·2v
145
146
147
148
149
150
151
152
153
154
155
156
188
189
190
191
192
193
194
195
196
197
198
199
200
201
202
203
204
205
206
207
208
209
210
211
212
213
214
215
216
217

FIG.5D.

European Patent Office

# EUROPEAN SEARCH REPORT

0C278147

Application number

EP 87 30 5153

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-3 783 340 (R.S. BECKER)<br>* claims 1-4; figures 1, 2 *<br>--- | 1-3,5 | H 02 H 11/00<br>G 01 R 31/02 |
| X | US-A-4 368 498 (D.E. NEUHOUSER)<br>* claim 1; figure 1 *<br>--- | 1 | |
| A | US-A-4 528 497 (G.P. ARATO)<br>* abstract; figure 5 *<br>--- | 5,7-9 | |
| A,D | EP-A-0 054 940 (SUMITOMO)<br>* claims 1-3 *<br>--- | | |
| A,D | GB-A-1 326 948 (I.K. JAMIESON)<br>* claim 1; figure 1 *<br>----- | | |

TECHNICAL FIELDS SEARCHED (Int. Cl.4)

G 01 R 31/02
H 02 H 11/00

The present search report has been drawn up for all claims

| Place of search | Date of completion of the search | Examiner |
|---|---|---|
| BERLIN | 15-09-1987 | LEMMERICH J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document